# EUROPEAN PATENT APPLICATION

(11) **EP 4 668 052 A1**
(43) Date of publication of application: **24.12.2025**
(21) Application number: 24773830.5
(22) Date of filing: 08.02.2024
(51) Int. Cl.: G06F 1/18

(54) **MEMORY CONNECTION APPARATUS, MEMORY CONNECTOR, AND MAINBOARD**

(30) Priority: 20.03.2023 CN 202310314980
(71) Applicant: Huawei Technologies Co., Ltd., Shenzhen, Guangdong 518129 (CN)
(72) Inventor: WEN, Chuanwei, Shenzhen, Guangdong 518129 (CN); LI, Jingfeng, Shenzhen, Guangdong 518129 (CN)
(74) Representative: Goddar, Heinz J.
(86) International application number: PCT/CN2024/076887
(87) International publication number: WO 2024/193262

(57) **Abstract**

This application discloses a memory connection apparatus, a memory connector, and a mainboard, and belongs to the field of computer technologies. A plurality of memory connectors are disposed on a circuit board of a memory connection apparatus for a same signal line, so that a pin of each memory connector can be connected to the signal line in a first state, and can be not in contact with the signal line in a second state. When a pin of one memory connector is in the first state, and a pin of a remaining memory connector is in the second state, the signal line is connected to only the one memory connector. In this case, no sudden impedance change occurs at a position that is on the signal line and at which no memory connector is connected. Therefore, when a signal on the signal line is transmitted to the connected memory connector, signal reflection caused by a sudden impedance change can be avoided. In this way, integrity of the signal is improved, and a data transmission bandwidth of the signal line is accordingly increased.

## Description

This application claims priority to Chinese Patent Application No. 202310314980.1, filed with the China National Intellectual Property Administration on March 20, 2023 and entitled "MEMORY CONNECTION APPARATUS, MEMORY CONNECTOR, AND MAINBOARD", which is incorporated herein by reference in its entirety.

### TECHNICAL FIELD

This application relates to the field of computer technologies, and in particular, to a memory connection apparatus, a memory connector, and a mainboard.

### BACKGROUND

Currently, a memory controller in an electronic device supports two memory slots (2 slots per channel, 2SPC), that is, a signal line of the memory controller is connected (for example, soldered) to the two memory slots, and each memory slot supports insertion of a memory module (dual inline memory module, DIMM).

The memory slot is also referred to as a memory connector. For ease of description, in the two memory slots connected to the signal line, a memory slot close to the memory controller is referred to as a near memory connector, and a memory slot far away from the memory controller is referred to as a remote memory connector. If no DIMM is inserted into a near memory connector connected to a signal line, and a DIMM is inserted into a remote memory connector, when the memory controller sends a signal to the DIMM in the remote memory connector through the signal line, the signal first arrives at the near memory connector connected to the signal line. In this case, a sudden impedance change occurs in the near memory connector due to signal bifurcation. As a result, the signal is reflected in the near memory connector, a part of the signal is reflected to the memory controller along the signal line, and another part of the signal continues to be transmitted to the remote memory connector along the signal line. Consequently, integrity of the signal on the memory controller is reduced, and a data transmission bandwidth of the signal line is accordingly decreased.

### SUMMARY

Embodiments of this application provide a memory connection apparatus, a memory connector, and a mainboard, to improve integrity of a signal on a same signal line corresponding to a plurality of memory connectors, and increase a data transmission bandwidth of the signal line. Technical solutions are as follows.

According to a first aspect, a memory connection apparatus is provided. A circuit board 1 is disposed in the memory connection apparatus, and a signal line 2 and a plurality of memory connectors 3 are disposed on the circuit board 1. The signal line 2 is disposed opposite to the plurality of memory connectors 3, a memory accommodation slot 31 for inserting a memory module is provided in the memory connector 3, a pin 33 is disposed on a slot wall 32 of the memory accommodation slot 31, and the pin 33 is configured to connect to the memory module DIMM. The pin 33 is connected to the signal line 2 in a first state, and the pin 33 is not in contact with the signal line 2 in a second state.

The plurality of memory connectors 3 are disposed on the circuit board 1 of the memory connection apparatus for a same signal line 2, so that the pin 33 of each memory connector 3 can be connected to the signal line in the first state, and can be not in contact with the signal line in the second state. When a pin of one memory connector 3 is in the first state and a pin of a remaining memory connector is in the second state, the signal line is connected to only the one memory connector 3. In this case, no sudden impedance change occurs at a position that is on the signal line and at which no memory connector is connected. Therefore, when a signal on the signal line 2 is transmitted to the connected memory connector, signal reflection caused by a sudden impedance change can be avoided. In this way, integrity of the signal is improved, and a data transmission bandwidth of the signal line 2 is increased.

In a possible implementation, a pin accommodation slot 321 for accommodating the pin 33 is provided in the slot wall 32, and the pin 33 includes a first contact part 331, a protruding connection part 332, an intermediate connection part 333, and a second contact part 334 that are sequentially connected. The first contact part 331 is located in the pin accommodation slot 321, and the protruding connection part 332 and the intermediate connection part 333 are both located in the memory accommodation slot 31. The protruding connection part 332 enables, in an extension state, the second contact part 334 to be connected to the signal line 2, and the protruding connection part 332 enables, in a non-extension state, the second contact part 334 not to be in contact with the signal line 2.

Based on the foregoing possible implementation, the pin 33 includes a protruding contact part 332 having an extension characteristic, and the protruding contact part 332 is located in the memory accommodation slot 31. When no DIMM is inserted into the memory accommodation slot 31, the protruding contact part 332 is in a non-extension state, so that the second contact part 334 is not in contact with the signal line 2, and the pin 33 is in the first state. When the DIMM is inserted into the memory accommodation slot 31, the DIMM presses the protruding contact part 332, so that the protruding contact part 332 is in an extension state, the protruding contact part 332 drives, through the intermediate connection part 333, the second contact part to be connected to the signal line 2, and the pin 33 is in the first state, to automatically control a status of the pin 33.

In a possible implementation, a pin accommodation slot 321 for accommodating the pin 33 is provided in the slot wall 32, and a reset plate 34 is disposed opposite to the top of the pin accommodation slot 321. The pin 33 may include a first contact part 331, an intermediate connection part 333, and a second contact part 334 that are sequentially connected. The first contact part 331 is located in the pin accommodation slot 321, extends out of the pin accommodation slot 321, and is connected to the reset plate 34, and the intermediate connection part 334 and the second contact part 334 are located in the memory accommodation slot 31. When the reset plate 34 is in contact with the top of the pin accommodation slot 321, the second contact part 334 is connected to the signal line 2. When the reset plate 34 is not in contact with the top of the pin accommodation slot 321, the second contact part 334 is not in contact with the signal line 2.

Based on the foregoing possible implementation, the reset plate 34 connected to the pin 33 is disposed on the top of the slot wall 32, so that a status of the pin 3 is controlled through the reset plate 34. An improvement manner is simple and easy to implement.

In a possible implementation, the memory connector 3 further includes a base 35. The base 35 and the slot wall 32 are disposed around the memory accommodation slot 31, the base 35 extends out of the bottom of the slot wall 32 and is connected to the circuit board 1, and the reset plate 34 is movably connected to the top of the base 35.

Based on the foregoing possible implementation, the reset plate 34 is movably connected to the base 35. An improvement manner is simple and easy to implement.

In a possible implementation, a handle 36 is disposed on the top of the reset plate 34, and the handle 36 is configured to movably connect the reset plate 34 to the top of the base 35.

Based on the foregoing possible implementation, the handle is disposed on the top of the reset plate 34. Therefore, it is convenient to movably connect the reset plate 34 to the base 35, and is convenient for the user to manually adjust a distance between the reset plate 34 and the top of the pin accommodation slot 321, to control a status of the pin 33 connected to the reset plate 34.

In a possible implementation, a memory fastener 37 is disposed on the base 35, and the memory fastener 37 is connected to the top of the reset plate 34 through an intermediate connector 38.

Based on the foregoing possible implementation, the reset plate 34 is fastened to the memory fastener 37 through the intermediate connector 38. When the DIMM is inserted into the memory accommodation slot 31, the intermediate connector 38 and the memory fastener 37 press the reset plate 34, so that the reset plate 34 presses the pin 33 in a direction facing the circuit board 1, to implement automatic control of the pin 33. This implementation is simple and easy to implement.

According to a second aspect, a memory connector is provided. A memory accommodation slot 31 is provided in the memory connector, and the memory accommodation slot 31 is configured to insert a memory module. A pin 33 is disposed on a slot wall 32 of the memory accommodation slot 31, and the pin 33 is configured to connect to the memory module. The pin 33 extends out of the memory accommodation slot 31 in a first state, and the pin 33 is located in the memory accommodation slot 31 in a second state.

In a possible implementation, a pin accommodation slot 321 is provided in the slot wall 32. The pin 33 includes a first contact part 331, a protruding connection part 332, an intermediate connection part 333, and a second contact part 334 that are sequentially connected. The first contact part 331 is located in the pin accommodation slot 321, and the protruding connection part 332 and the intermediate connection part 333 are both located in the memory accommodation slot 31. The protruding connection part 332 enables, in an extension state, the second contact part 334 to extend out of the memory accommodation slot 31, and the protruding connection part 332 enables, in a non-extension state, the second contact part 334 to be located in the memory accommodation slot 31.

In a possible implementation, a pin accommodation slot 321 is provided in the slot wall 32, and a reset plate 34 is disposed opposite to the top of the pin accommodation slot 321. The pin 33 includes a first contact part 331, an intermediate connection part 333, and a second contact part 334 that are sequentially connected. The first contact part 331 is located in the pin accommodation slot 321, extends out of the pin accommodation slot 321, and is connected to the reset plate 34, and the intermediate connection part 334 and the second contact part 334 are located in the memory accommodation slot 31. When the reset plate 34 is in contact with the top of the pin accommodation slot 321, the second contact part 334 extends out of the memory accommodation slot 31. When the reset plate 34 is not in contact with the top of the pin accommodation slot 321, the second contact part 334 does not extend out of the memory accommodation slot 31.

In a possible implementation, the memory connector 3 further includes a base 35. The base 35 and the slot wall 32 are disposed around the memory accommodation slot 31, the base 35 extends out of the bottom of the slot wall 32 and is connected to the circuit board 1, and the reset plate 34 is movably connected to the top of the base 35.

In a possible implementation, a handle 36 is disposed on the top of the reset plate 34, and the handle 36 is configured to movably connect the reset plate 34 to the top of the base 35.

In a possible implementation, a memory fastener 37 is disposed on the base 35, and the memory fastener 37 is connected to the top of the reset plate 34 through an intermediate connector 38.

According to a third aspect, a mainboard is provided. The mainboard includes the memory connection apparatus according to any one of the first aspect or the possible implementations of the first aspect.

### BRIEF DESCRIPTION OF DRAWINGS

FIG. 1 is a side sectional view of a memory connection apparatus 100 according to an embodiment of this application;
FIG. 2 is a main view of a memory connection apparatus 100 according to an embodiment of this application;
FIG. 3 is a partial top view of a memory connection apparatus 100 according to an embodiment of this application;
FIG. 4 is a side sectional view of a memory connection apparatus 200 according to an embodiment of this application;
FIG. 5 is a side sectional view of a memory connection apparatus 300 according to an embodiment of this application;
FIG. 6 is another side sectional view of a memory connection apparatus 300 according to an embodiment of this application;
FIG. 7 is a partial top view of a memory connector apparatus 300 according to an embodiment of this application;
FIG. 8 is a main view of a memory connector apparatus 300 according to an embodiment of this application; and
FIG. 9 is another main view of a memory connector apparatus 300 according to an embodiment of this application.

### DESCRIPTION OF EMBODIMENTS

To make the objectives, technical solutions, and advantages of this application clearer, the following further describes the implementations of this application in detail with reference to the accompanying drawings.

This application provides a memory connector. A slidable pin is disposed in the memory connector. The memory connector is used in a memory connection apparatus, so that pins of a plurality of memory connectors on the memory connection apparatus can slide toward a same signal line to connect to the signal line, or can slide in a direction away from the signal line to disconnect from the signal line.

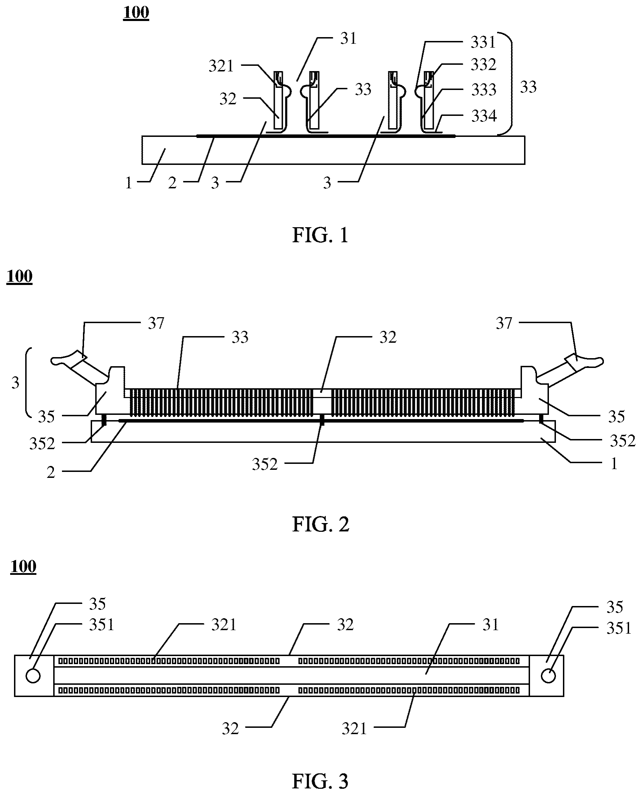

The following describes a structure of the memory connector apparatus with reference to FIG. 1 to FIG. 3. FIG. 1 and FIG. 3 are respectively a side sectional view, a main view, and a partial top view of a memory connection apparatus 100 according to an embodiment of this application.

As shown in FIG. 2 and FIG. 1, the memory connection apparatus 100 includes a circuit board 1, and the circuit board 1 may be a printed circuit board (printed circuit board, PCB). A signal line 2 is disposed on the circuit board 1, and the signal line 2 is configured to transmit a signal. For example, when the signal line 2 is connected to a memory controller, the signal line 2 is used as a memory channel of the memory controller to transmit a signal sent by the memory controller or transmit a signal to the memory controller.

In a possible implementation, at least one signal line 2 may be disposed on the circuit board 1, and each signal line 2 is used as a memory channel of the memory controller. For any signal line 2 on the circuit board 1, a plurality of memory connectors 3 are further disposed on the circuit board 1, and the signal line 2 is disposed opposite to the plurality of memory connectors 3, where the opposite disposition means that there is a specific distance between the signal line 2 and the memory connection 1.

As shown in FIG. 1, for the signal line 2, two memory connectors 3 are disposed on the circuit board 1. In some other embodiments, for a same signal line 2, more than two or less than two memory connectors 3 may be disposed on the circuit board 1. A quantity of memory connectors 3 corresponding to a same signal line 2 on the circuit board 1 is not limited in this embodiment of this application.

In a possible implementation, the plurality of connectors 3 are disposed in parallel on the circuit board 1. For ease of description, the following uses any one of the plurality of memory connectors 3 as an example to describe a connection relationship between the memory connector 3 and the circuit board 1 and a structure of the memory connector 3.

As shown in FIG. 1 and FIG. 3, a memory accommodation slot 31 is provided in the memory connector 3, where the memory accommodation slot 31 is configured to insert a memory module (DIMM), and an opening of the memory accommodation slot 31 faces upward, to facilitate insertion of the DIMM.

In a possible implementation, the memory connector 3 includes a slot wall 32 and a base 35. The base 35 and the slot wall 32 are disposed around the memory accommodation slot 31, that is, the memory accommodation slot 31 is disposed between the slot wall 32 and the base 35.

As shown in FIG. 3, the memory connector 3 includes two bases 35, the two bases 35 are disposed opposite to each other, and two slot walls 32 are disposed between the two bases 35. Left and right sides of the two slot walls 32 are connected to the two bases 35, the two slot walls 32 are disposed in parallel, and there is a specific distance between the two slot walls 32, so that space between the two slot walls 32 and the two bases 35 forms the memory accommodation slot 32.

As shown in FIG. 2, each base 35 extends out of the bottom of the slot wall 32 and is connected to the circuit board 1, so that the bottom of the slot wall 32 is not in contact with the circuit board 1. With reference to FIG. 2 and FIG. 3, the bottom of the base 35 is provided with a first positioning hole 351 with a downward opening, a first connector is disposed in the first positioning hole 351, and the first connector 352 extends downward out of the first positioning hole 351 to connect to the circuit board 1, to fasten the memory connector 3 to the circuit board 1. In addition, because the first connector 352 extends out of the first positioning hole 351, a gap is formed between the slot wall 32 and the circuit board 1.

For example, as shown in FIG. 2, a first connector 352 is also disposed at the bottom of the side wall 32. The first connector 352 is connected to the circuit board 1, to reinforce the memory connector 32. The first connector 352 at the bottom of the side wall 32 is an optional component. In some other embodiments, no first connector 352 is disposed at the bottom of the side wall 32.

As shown in FIG. 1, a pin 33 is disposed on each slot wall 32, and the pin 33 is configured to connect to the DIMM. A part of the pin 33 is disposed on an inner side of the slot wall 32, so that the part may be located in the memory accommodation slot 31. When the DIMM is inserted into the memory accommodation slot 31, the part that is of the pin 33 and that is located in the memory accommodation slot 31 is in contact with a gold finger of the DIMM, so that the pin 33 is connected to the DIMM.

As shown in FIG. 2, a plurality of pins 33 are disposed on the slot wall 32. The plurality of pins 33 are parallel to each other to form a row of pins 33. Each pin 33 in the plurality of pins 33 corresponds to one gold finger of the DIMM. When the DIMM is inserted into the memory accommodation slot 31, each pin 33 is connected to the corresponding gold finger.

As shown in FIG. 1 and FIG. 3, a plurality of pin accommodation slots 321 are provided in the slot wall 32, each pin accommodation slot 321 corresponds to one pin 33, and each pin accommodation slot 321 is configured to accommodate the corresponding pin 33. For example, a part of the pin 33 is located in the corresponding pin accommodation slot 321, and the other part is located in the memory accommodation slot 31 along the inner side of the slot wall 32, so that when a DIMM is inserted into the memory accommodation slot 31, the part that is of the pin 33 and that is located in the memory accommodation slot 31 can be in contact with the DIMM.

The pin 33 disposed on the slot wall 32 is a movable pin, and an end (referred to as a first end) that is of the pin 33 and that is close to the circuit board 1 can slide along the inner side of the slot wall 32. For example, when the first end of the pin 33 slides along the slot wall 32 in a direction facing the circuit board 1, when the first end slides to the circuit board 1, the first end is connected to the signal line 2 on the circuit board 1. In this case, the pin 33 is in a first state, that is, the pin 33 is connected to the signal line 2 in the first state. When the first end of the pin 33 slides along the slot wall 32 in a direction away from the circuit board 1, the first end of the pin 33 gradually moves away from the circuit board 1, so that the first end is disconnected from the signal line 2 on the circuit board 1, and is not in contact with the signal line 2. In this case, the pin 33 is in a second state, that is, the pin 33 is not in contact with the signal line 2 in the second state.

A plurality of memory connectors 3 are disposed on the circuit board 1 of the memory connection apparatus 300 for a same signal line 2, so that a pin 33 of each memory connector 3 can be connected to the signal line 2 on the circuit board 1 in the first state, and can be not in contact with the signal line 2 in the second state. In this case, in the plurality of memory connectors 3, when only a pin 33 of one memory connector 3 is in the first state, and a pin 33 of a remaining memory connector is in the second state, the signal line 2 is connected to only the one memory connector 3 whose pin 33 is in the first state, but is not connected to the remaining memory connector. When a signal is transmitted in the signal line, because the remaining memory connector is not connected to the signal line, a sudden impedance change does not occur in a process of transmitting the signal to the connected memory connector. In this way, signal reflection caused by a sudden impedance change can be avoided, integrity of the signal on the signal line 2 is improved, and a data transmission bandwidth of the signal line 2 is increased.

For the pin 33 in the memory connector 3, this embodiment of this application provides the following two types of pins 33 of different structures. The following separately describes structures and working principles of the two types of pins 33.

### (1) First type of pin 33

As shown in FIG. 1, the pin 33 includes a first contact part 331, a protruding connection part 332, an intermediate connection part 333, and a second contact part 334 that are sequentially connected.

The first contact part 331 is located in the pin accommodation slot 321. For example, the top of the first contact part 331 is connected to the top of the slot wall 32 on which the pin accommodation slot 321 is located, so that the first contact part 331 is fastened in the pin accommodation slot 321, to fasten the pin 33 to the slot wall 32.

Both the protruding connection part 332 and the intermediate connection part 333 are located in the memory accommodation slot 31, and the protruding connection part 332 and the intermediate connection part 333 are configured to connect the DIMM. The protruding connection part 332 protrudes in a direction away from the slot wall 32, that is, protrudes facing the memory accommodation slot. A protrusion shape of the protruding connection part 332 may be an arc or another shape. A protrusion shape and a protrusion degree of the protruding connection part 332 are not limited in this embodiment of this application.

In a possible implementation, the protruding connection part 332 is an elastic connector, and the protruding connection part 332 can extend to the intermediate connection part 333 when a force is applied, so that the protruding connection part 332 drives, through the intermediate connection part 333, the second contact part 334 to extend to the circuit board 1. In this case, the protruding connection part 332 is in an extension state. The protruding connection part 332 is in a non-extension state when no force is applied.

The second contact part 334 is the first end of the pin 33, and is configured to connect to the signal line 2. The second contact part 334 may be located in the memory accommodation slot 31, or may extend out of the memory accommodation slot 31. As shown in FIG. 1, when the protruding connection part 332 is in the non-extension state, the second contact part 334 extends out of the memory accommodation slot 31, and is located in the gap between the slot wall 32 and the circuit board 1. In another possible implementation, when the protruding connection part 332 is in the non-extension state, the protruding connection part 332 is located in the memory accommodation slot 31, and does not extend out of the memory accommodation slot 31.

When the protruding connection part 332 is in the extension state, the protruding connection part 332 extends in a direction facing the intermediate connection part 333, so that the intermediate connection part 333 drives the second contact part 334 to slide in a direction facing the circuit board 1. When the second contact part 334 slides to (that is, extends to) the circuit board 1, the second contact part 334 is connected to the signal line 2 on the circuit board 1. In this case, the pin 33 is in the first state.

When the protruding connection part 332 is in the non-extension state, the second contact part 334 is located in the gap between the slot wall 32 and the circuit board 1 or in the memory accommodation slot 31. Therefore, the second contact part 334 does not reach the circuit board 1 and is not in contact with the signal line 2 on the circuit board 1. In this case, the pin 33 is in the second state.

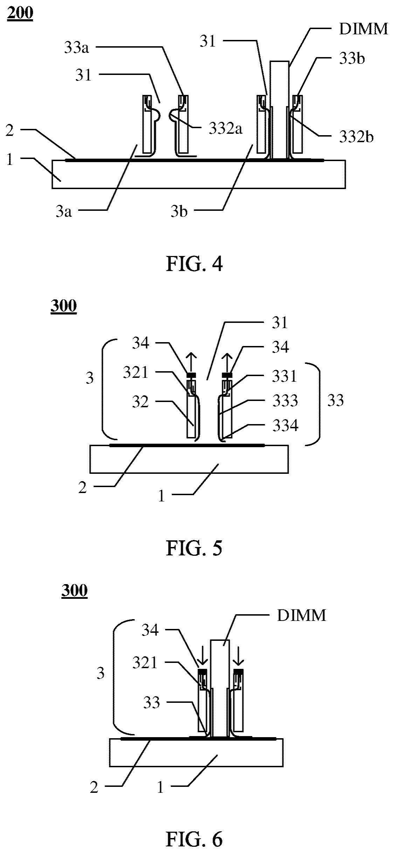

Whether the protruding connection part 332 is in the extension state is determined by whether the DIMM is inserted into the memory accommodation slot 31. FIG. 4 is a side sectional view of a memory connection apparatus 200 according to an embodiment of this application. For example, the memory connection apparatus 200 includes two memory connectors 3: a memory connector 3a and a memory connector 3b. For ease of description, a pin 33 in the memory connector 3a is referred to as a pin 33a, a protruding connection part 332 of the pin 33a is referred to as a protruding connection part 332a, a pin 33 in the memory connector 3b is referred to as a pin 33b, and a protruding connection part 332 of the pin 33b is referred to as a protruding connection part 332b.

As shown in the memory connector 3a, no DIMM is inserted into a memory accommodation slot 31 of the memory connector 3a. In this case, no force is applied to the protruding connection part 332a of the pin 33a, the protruding connection part 332a is in a non-extension state, a second contact part 334 of the pin 33a is located in a gap between a slot wall 32 and a circuit board 1, and the second contact part 334 of the pin 33a is not in contact with a signal line 2 on the circuit board 1. In this case, the pin 33a is in a first state.

As shown in the memory connector 3b, when a DIMM is inserted into a memory accommodation slot 31 of the memory connector 3b, in an insertion process, the DIMM applies a downward force to the protruding connection part 332b of the pin 33b, so that the protruding connection part 332b extends downward and is in an extension state. In a process of extending downward, the protruding connection part 332b drives a second contact part 334 of the pin 33b to move in a direction facing the circuit board 1, until the second contact part 334 moves to the circuit board 1 and is connected to the signal line 2 on the circuit board 1. In this case, the pin 33b is in a second state.

As shown in FIG. 4, when a signal transmitted to the memory connector 3b is in the signal line 2, because the signal line 2 is not connected to the pin 33a of the memory connector 3a, a sudden impedance change does not occur at a position corresponding to the pin 33a on the signal line 2 relative to another position. When the signal is transmitted to this position, signal reflection is not caused due to a sudden impedance change. In this way, integrity of the signal is improved, and a data transmission bandwidth of the signal line 2 is increased.

The first type of pin 33 provided in this embodiment of this application includes the protruding contact part 332 having an extension characteristic, and the protruding contact part 332 is located in the memory accommodation slot 31. When no DIMM is inserted into the memory accommodation slot 31, the protruding contact part 332 is in the non-extension state, so that the second contact part 334 is not in contact with the signal line 2, and the pin 33 is in the first state. When the DIMM is inserted into the memory accommodation slot 31, the DIMM presses the protruding contact part 332, so that the protruding contact part 332 is in the extension state, the protruding contact part 332 drives, through the intermediate connection part 333, the second contact part to be connected to the signal line 2, and the pin 33 is in the first state, to automatically control a status of the pin 33.

### (2) Second type of pin 33

FIG. 5 is a side sectional view of a memory connection apparatus 300 according to an embodiment of this application. FIG. 5 shows one memory connector 3 corresponding to a same signal line 2 in the memory connection apparatus 300. It should be understood that the signal line 2 may correspond to more than one memory connector 3 in the memory connection apparatus 300.

As shown in FIG. 5, the second type of pin 33 is disposed on a side wall 32 of the memory connector 3. The second type of pin 33 includes a first contact part 331, an intermediate connection part 333, and a second contact part 334 that are sequentially connected. In this case, no protruding connection part exists between the first contact part 331 and the intermediate connection part 333.

The first contact part 331 is located in a pin accommodation slot 321, extends out of the pin accommodation slot 321, and is connected to a reset plate 34. As shown in FIG. 5, the first contact part 331 is connected to the bottom of the reset plate 34, to fasten the pin 33 to the reset plate 34. Both the intermediate connection part 333 and the second contact part 334 are located in a memory accommodation slot 31. In some other embodiments, the second contact part 334 may also be located in a gap between the slot wall 32 and a circuit board 1.

In addition, the reset plate 34 is disposed opposite to the top of the pin accommodation slot 321 of the memory connector 3, the reset plate 34 is connected to the second type of pin 33, and the reset plate 34 is configured to drive the connected pin 33 to slide upward and downward along the side wall 32. As shown in FIG. 5, the first contact part 331 of the pin 33 extends out of the pin accommodation slot 321, and is connected to the bottom of the reset plate 34, to fasten the pin 33 to the reset plate 34.

As shown in FIG. 5, when the first contact part 331 of the pin 33 extends out of the pin accommodation slot 321, the reset plate 34 is not in contact with the top of the pin accommodation slot 321. In this case, the pin 33 is in a first state, and the second contact part 334 of the pin 33 is not in contact with the signal line 2.

The reset plate 34 is movably connected to the top of the pin accommodation slot 321, and the reset plate 34 can move in a direction facing the pin accommodation slot 321 (that is, downward). FIG. 6 is another side sectional view of the memory connection apparatus 300 according to an embodiment of this application. As the reset plate 34 moves downward, the reset plate 34 gradually approaches the top of the pin accommodation slot 321 until the reset plate 34 is in contact with the top of the pin accommodation slot 321. As the reset plate 34 moves downward, the pin 33 is driven to slide in a direction facing the circuit board 1. When the reset plate 34 is in contact with the top of the pin accommodation slot 321, the second contact part 334 slides to the circuit board 1, and is connected to the signal line 2 on the circuit board 1. In this case, the pin 33 is in a second state. When the pin 33 is in the second state, a user may insert a DIMM into the memory accommodation slot 31. When a signal is transmitted to the DIMM in the signal line 2, the signal is transmitted to the DIMM through the pin 33 in the second state.

The reset plate 34 connected to the pin 33 is disposed on the top of the slot wall 32, so that a status of the pin 3 is controlled through the reset plate 34. An improvement manner is simple and easy to implement.

The reset plate 34 may be movably connected to the top of the pin accommodation slot 321 in the following Manner 1 or Manner 2.

Manner 1: The reset plate 34 is movably connected to the top of a base 35.

In a possible implementation, a handle 36 is disposed on the top of each reset plate 34, and the handle 36 is configured to movably connect the reset plate 34 to the top of the base 35.

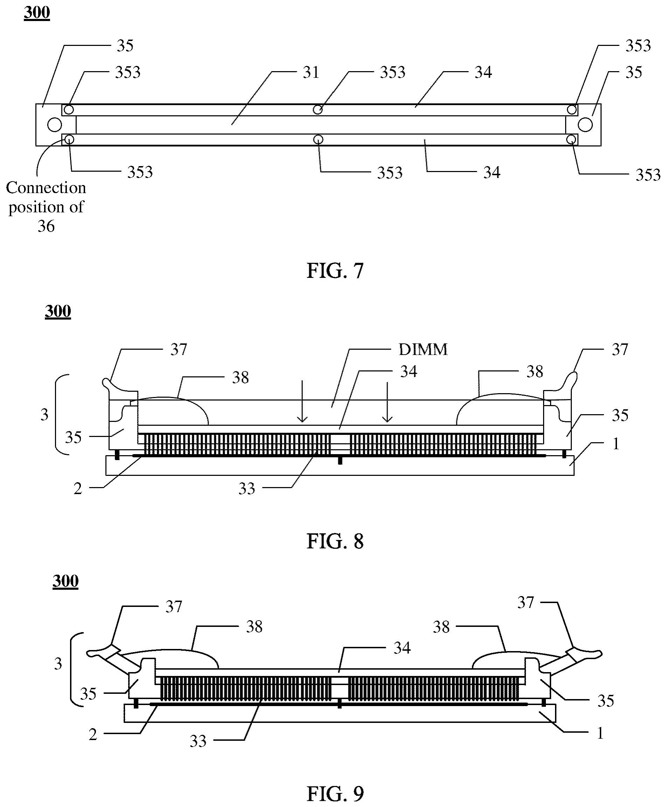

For example, FIG. 7 is a local top view of the memory connector apparatus 300 according to an embodiment of this application. The top of the base 35 may be located on a same plane as the top of the pin accommodation slot 321 or the top of the base 35 extends out of the top of the pin accommodation slot 321. Two ends of each reset plate 34 are provided with second positioning holes 353, and the handle 36 movably connects the reset plate 34 to the top of the base 35 through the second positioning holes 353. There may be a first connection state and a second connection state between the handle 36 and the top of the base 35. When the handle 36 and the top of the base 35 are in the first connection state, the reset plate 34 is in contact with the top of the pin accommodation slot 321. When the handle 36 and the top of the base 35 are in the second connection state, the reset plate 34 is not in contact with the top of the pin accommodation slot 321.

When the DIMM needs to be inserted into the memory accommodation slot 31, the user manually adjusts a connection state between the handle 36 and the top of the base 35 to the first connection state, so that the reset plate 34 is in contact with the top of the pin accommodation slot 321, and the pin 33 connected to the reset plate 34 is in the first state. After the DIMM is inserted into the memory accommodation slot 31, the DIMM is connected to the signal line 2 through the pin 33, to receive a signal on the signal line 2 or send a signal to the signal line 2.

When no DIMM is inserted into the memory accommodation slot 31 of the memory connector 3, the user manually adjusts a connection state between the handle 36 and the top of the base 35 to the second connection state, so that the reset plate 34 is not in contact with the top of the pin accommodation slot 321, and the pin 33 connected to the reset plate 34 is in the second state.

The handle is disposed on the top of the reset plate 34. Therefore, it is convenient to movably connect the reset plate 34 to the base 35, and is convenient for the user to manually adjust a distance between the reset plate 34 and the top of the pin accommodation slot 321, to control a status of the pin 33 connected to the reset plate 34.

In another possible implementation, an area of the reset plate 34 on the top of the slot wall 32 is further provided with a second positioning hole 353, and the handle 36 movably connects the reset plate 34 to the top of the slot wall 32 (namely, the top of the pin accommodation slot 321). There may also be a first connection state and a second connection state between the handle 36 and the top of the slot wall 32. When the handle 36 and the top of the slot wall 32 are in the first connection state, the reset plate 34 is not in contact with the top of the pin accommodation slot 321. When the handle 36 and the top of the slot wall 32 are in the second connection state, the reset plate 34 is in contact with the top of the pin accommodation slot 321. The reset plate 34 on the top of the slot wall 32 is connected to the handle 36, so that the reset plate can be more stable. It should be understood that this implementation is an optional manner. In some other embodiments, the area of the reset plate 34 on the top of the slot wall 32 is not provided with the second positioning hole 353, and is not connected to the handle 36.

In another possible implementation, no handle 36 is disposed on the top of the reset plate 34, an elastic connector is disposed on the top of the reset plate 34 and the top of the base 35, and the elastic connector has a first elastic state and a second elastic state. When the elastic connector is in the first elastic state, the pin 33 connected to the reset plate 34 is in the first state. When the elastic connector is in the second elastic state, the pin 33 connected to the reset plate 34 is in the second state. In this case, the reset plate 34 is equivalent to a button mounted on the top of the base 35. When the DIMM needs to be inserted into the memory accommodation slot 31, the user presses the reset plate 34, so that the elastic connector connected to the reset plate 34 is in the first elastic state. After the DIMM is removed from the memory accommodation slot 31 of the memory connector 3, the user presses the reset plate 34 again, so that the elastic connector connected to the reset plate 34 is reset to the second elastic state. This implementation is simple, and it is convenient for the user to adjust the status of the pin 33.

Manner 2: A memory fastener 37 is disposed on the base 35, and the memory fastener 37 is connected to the top of the reset plate 34 through an intermediate connector 38.

A working principle of the memory fastener 37 is described as follows: As shown in FIG. 2, a memory fastener 37 is disposed on each base 35, and the memory fastener 37 can move in a direction away from the base 35 by using the base 35 as an axis, so that an included angle is formed between the memory fastener 37 and the base 35. In this case, the memory fastener 37 is in an open state. After being in the open state, the memory fastener 37 may further move in a direction facing the base 35, so that the memory fastener 37 is fastened to the base 35, to eliminate the included angle between the memory fastener 37 and the base 35. In this case, the memory fastener 37 is in a closed state. In a process of inserting the DIMM into the memory accommodation slot 31, as the DIMM is inserted, the memory fastener 37 in the open state is gradually fastened to the base 35. After the DIMM is inserted, the memory fastener 37 is in the closed state. Before the DIMM is removed from the memory accommodation slot 31, the memory fastener 37 fastened to the base 35 is manually opened, so that the memory fastener 37 is in the open state. Then, the DIMM is removed.

In view of this, FIG. 8 is a main view of the memory connector apparatus 300 according to an embodiment of this application. The intermediate connector 38 is disposed between the memory fastener 37 and the reset plate 34. In the process of inserting the DIMM into the memory accommodation slot 31, the memory fastener 37 is gradually fastened to the base 35 until the memory fastener 37 is in the closed state. In a fastening process, the memory fastener 37 presses the reset plate 34 downward through the intermediate connector 38, so that the reset plate 34 moves downward. In a process of moving downward, the reset plate 34 drives the pin 33 to move downward to gradually approach the circuit board 1, until the pin 33 is connected to the signal line 2 on the circuit board 1, and the pin 33 is in the first state.

For a scenario in which the DIMM is removed, FIG. 9 is another main view of the memory connector apparatus 300 according to an embodiment of this application. The memory fastener 37 is manually opened. In an opening process, as the included angle between the memory fastener 37 and the base 35 increases, the memory fastener 37 drives, through the intermediate connector 38, the reset plate 34 to move upward until the memory fastener 37 is in the open state. In a process of moving upward, the reset plate 34 drives the pin 33 to move upwards, so that the pin 33 moves gradually away from the circuit board 1. Finally, the pin 33 is not in contact with the signal line 2 on the circuit board 1, and the pin 33 is in the second state.

The reset plate 34 is fastened to the memory fastener 37 through the intermediate connector 38. When the DIMM is inserted into the memory accommodation slot 31, the intermediate connector 38 and the memory fastener 37 press the reset plate 34, so that the reset plate 34 presses the pin 33 in a direction facing the circuit board 1, to implement automatic control of the pin 33. This implementation is simple and easy to implement.

An embodiment of this application further provides a memory connector. The memory connector may be any memory connector 3 in FIG. 1 to FIG. 9. A structure of the memory connector is not described herein again in this embodiment of this application.

An embodiment of this application further provides a mainboard. The mainboard includes any memory connection apparatus in FIG. 1 to FIG. 9. A structure of the memory connection apparatus is not described herein again in this embodiment of this application.

In descriptions of this application, "at least one" means one or more, and "a plurality of" means two or more. Terms such as "first" and "second" do not limit a quantity and an execution sequence, and the terms such as "first" and "second" do not indicate a definite difference.

In this application, the term "example" or "for example" is used to represent giving an example, an illustration, or a description. Any embodiment or design scheme described as an "example" or "for example" in this application should not be explained as being more preferred or having more advantages than another embodiment or design scheme. Exactly, use of the word like "example" or "for example" is intended to present a related concept in a specific manner.

The foregoing descriptions are merely optional embodiments of this application, but are not intended to limit this application. Any modification, equivalent replacement, or improvement made without departing from the spirit and principle of this application should fall within the protection scope of this application.

## Claims

1. A memory connection apparatus, wherein the memory connection apparatus comprises a circuit board (1), a signal line (2) and a plurality of memory connectors (3) are disposed on the circuit board (1), and the signal line (2) is disposed opposite to the plurality of memory connectors (3);
a memory accommodation slot (31) is provided in the memory connector (3), and the memory accommodation slot (31) is configured to insert a memory module;
a pin (33) is disposed on a slot wall (32) of the memory accommodation slot (31), and the pin (33) is configured to connect to the memory module; and
the pin (33) is connected to the signal line (2) in a first state, and the pin (33) is not in contact with the signal line (2) in a second state.

2. The apparatus according to claim 1, wherein a pin accommodation slot (321) is provided in the slot wall (32), and the pin (33) comprises a first contact part (331), a protruding connection part (332), an intermediate connection part (333), and a second contact part (334) that are sequentially connected;
the first contact part (331) is located in the pin accommodation slot (321), and the protruding connection part (332) and the intermediate connection part (333) are both located in the memory accommodation slot (31); and
the protruding connection part (332) enables, in an extension state, the second contact part (334) to be connected to the signal line (2), and the protruding connection part (332) enables, in a non-extension state, the second contact part (334) not to be in contact with the signal line (2).

3. The apparatus according to claim 1, wherein a pin accommodation slot (321) is provided in the slot wall (32), and a reset plate (34) is disposed opposite to a top of the pin accommodation slot (321);
the pin (33) comprises a first contact part (331), an intermediate connection part (333), and a second contact part (334) that are sequentially connected, the first contact part (331) is located in the pin accommodation slot (321), extends out of the pin accommodation slot (321), and is connected to the reset plate (34), and the intermediate connection part (334) and the second contact part (334) are located in the memory accommodation slot (31); and
when the reset plate (34) is in contact with the top of the pin accommodation slot (321), the second contact part (334) is connected to the signal line (2), or when the reset plate (34) is not in contact with the top of the pin accommodation slot (321), the second contact part (334) is not in contact with the signal line (2).

4. The apparatus according to claim 3, wherein the memory connector (3) further comprises a base (35), wherein the base (35) and the slot wall (32) are disposed around the memory accommodation slot (31), the base (35) extends out of a bottom of the slot wall (32) and is connected to the circuit board (1), and the reset plate (34) is movably connected to a top of the base (35).

5. The apparatus according to claim 4, wherein a handle (36) is disposed on a top of the reset plate (34), and the handle (36) is configured to movably connect the reset plate (34) to the top of the base (35).

6. The apparatus according to claim 4, wherein a memory fastener (37) is disposed on the base (35), and the memory fastener (37) is connected to a top of the reset plate (34) through an intermediate connector (38).

7. A memory connector, wherein a memory accommodation slot (31) is provided in the memory connector, and the memory accommodation slot (31) is configured to insert a memory module;
a pin (33) is disposed on a slot wall (32) of the memory accommodation slot (31), and the pin (33) is configured to connect to the memory module; and
the pin (33) extends out of the memory accommodation slot (31) in a first state, and the pin (33) is located in the memory accommodation slot (31) in a second state.

8. The apparatus according to claim 7, wherein a pin accommodation slot (321) is provided in the slot wall (32), and the pin (33) comprises a first contact part (331), a protruding connection part (332), an intermediate connection part (333), and a second contact part (334) that are sequentially connected;
the first contact part (331) is located in the pin accommodation slot (321), and the protruding connection part (332) and the intermediate connection part (333) are both located in the memory accommodation slot (31); and
the protruding connection part (332) enables, in an extension state, the second contact part (334) to extend out of the memory accommodation slot (31), and the protruding connection part (332) enables, in a non-extension state, the second contact part (334) to be located in the memory accommodation slot (31).

9. The apparatus according to claim 7, wherein a pin accommodation slot (321) is provided in the slot wall (32), and a reset plate (34) is disposed opposite to a top of the pin accommodation slot (321);
the pin (33) comprises a first contact part (331), an intermediate connection part (333), and a second contact part (334) that are sequentially connected, the first contact part (331) is located in the pin accommodation slot (321), extends out of the pin accommodation slot (321), and is connected to the reset plate (34), and the intermediate connection part (334) and the second contact part (334) are located in the memory accommodation slot (31); and
when the reset plate 3(4) is in contact with the top of the pin accommodation slot (321), the second contact part (334) extends out of the memory accommodation slot (31), or when the reset plate (34) is not in contact with the top of the pin accommodation slot (321), the second contact part (334) does not extend out of the memory accommodation slot (31).

10. A mainboard, wherein the mainboard comprises the memory connection apparatus according to any one of claims 1 to 6.
